# EUROPEAN PATENT APPLICATION

(11) **EP 1 684 501 A1**
(43) Date of publication of application: **26.07.2006**
(21) Application number: 05028580.8
(22) Date of filing: 28.12.2005
(51) Int. Cl.: H04N 5/225, H01L 31/0203, H01L 31/0232, G02B 7/00

(54) **Image sensor module**

(30) Priority: 24.01.2005 KR 2005006298
(71) Applicant: Samsung Electronics Co., Ltd., Yeongtong-gu Suwon-si, Gyeonggi-do (KR)
(72) Inventor: Kim, Sang-Ho, Yeongtong-gu Suwon-si Gyeonggi-do (KR); Lee, Hyun-Ju, Yeongtong-gu Suwon-si Gyeonggi-do (KR)
(74) Representative: Lang, Johannes

(57) **Abstract**

Tightness and maintenance of the light receiving part due to an automatic arrangement function provided by the projecting part, while minimizing a phenomenon that burrs or foreign bodies in a hole of a substrate intrude onto the light receiving part.
While the invention has been shown and described with reference to a certain preferred embodiment thereof, it will be understood by those skilled in the art that various changes in form and details may be made therein without departing from the scope of the invention as defined by the appended claims.

## Description

### BACKGROUND OF THE INVENTION

### 1. Field of the Invention

The present invention relates generally to an image sensor and in particular, to an image sensor module whose light receiving part is sealed up using a chip on film (COF) process to detect an image by receiving light from the outside.

### 2. Description of the Related Art

A trend in portable phones having camera functions, such as an automatic focusing function and an optical zoom function, is for achieving a high resolution of a digital camera level and a miniaturization. A process of packaging an image sensor included in the camera module typically includes a chip on board (COB) process and a chip on film (COF) process. For a high resolution camera module, the COB process is preferable due to the stability of the process, and for a low resolution camera module of less than 1 mega pixels, the COF process is preferable due to easiness of mass-production. The image sensor packaging process enables the image sensor to exchange an electrical signal and protect the imaging devices. The image sensor is a semiconductor chip used to convert an image signal to an electrical signal which is largely divided into a complementary metal oxide semiconductor (CMOS) image sensor and a charger coupled devices (CCD) image sensor.

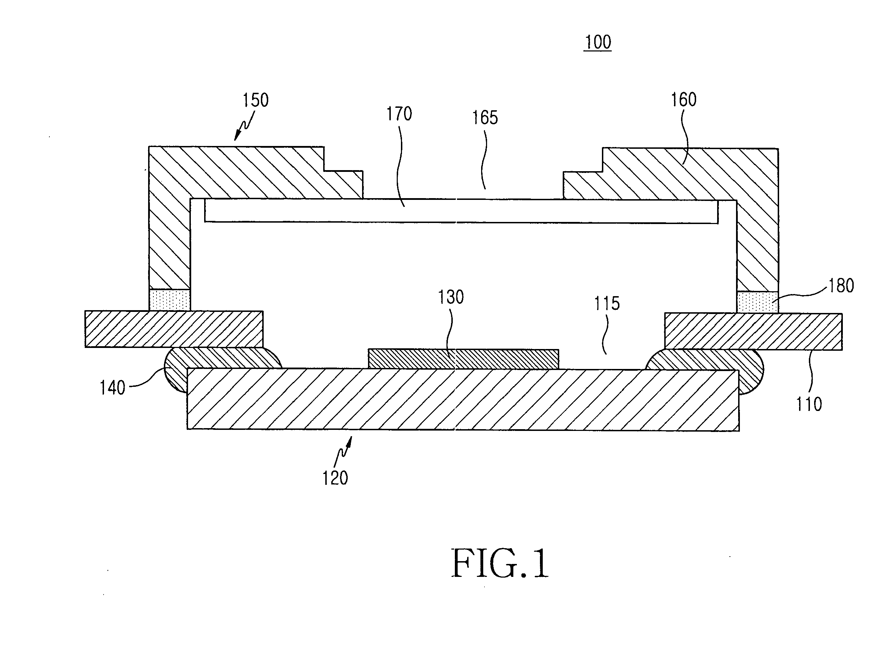

FIG. 1 is a sectional diagram of a conventional image sensor module 100 whose light receiving part 130 is sealed up according to the COF process. As shown, the image sensor module 100 mainly includes a flexible printed circuit board (FPCB) 110, an infrared (IR) filter assembly 150, and an image sensor 120.

The FPCB 110 has a rectangular hole 115, and an anisotropic conductive film (ACF) 140, which is a conductive adhesive agent, is deployed on a lower surface of the FPCB 110 to be deployed around the hole 115.

The image sensor 120 includes the light receiving part 130, which is exposed on its surface and comprised of a plurality of pixels, and bumps, which are external connection terminals deployed around the light receiving part 130, formed on its surface. The image sensor 120 is attached to the lower surface of the FPCB 110 so that the bumps contact with the ACF 140. The light receiving part 130 is exposed through the hole 115 of the FPCB 110.

The IR filter assembly 150 includes a hollow cylinder shaped housing 160 whose lower end is open and formed on the upper surface a circular hole 165, and an IR filter 170 attached to an upper surface of the inside of the housing 160 to cover a lower end of the hole 165. After an epoxy 180 is spread on an upper surface of the FPCB 110, the lower end of the housing 160 is attached to the upper surface of the FPCB 110 to cover an upper side of the hole 165 of the FPCB 110.

The light receiving part 130 maintains air tightness using the IR filter assembly 150 and the image sensor 120.

As described above, a method of fabricating the conventional image sensor module 100 adopts a method of spreading the epoxy 180 on the upper surface of the FPCB 110 and adhering the housing 160 on the FPCB 110 by pushing the housing 160 and spreading out the epoxy 180. However, if tilting occurs during the process of pushing the housing 160, the air tightness of the light receiving part 130 cannot be maintained due to intermittence of the epoxy 180 or generation of bubbles in the epoxy 180.

In addition, burrs generated in a process of forming the hole 115 on the FPCB 110 or foreign bodies in the hole 115 often intrude onto the light receiving part 130 by a shock from the outside.

### SUMMARY OF THE INVENTION

An object of the present invention is to substantially solve at least the above problems and/or disadvantages and to provide at least the advantages below. Accordingly, an object of the present invention is to provide an image sensor module that enables easy maintenance of air tightness in a light receiving part and a minimization of a phenomenon in which burrs or foreign bodies in an opening of a printed circuit board (PCB) intrude onto the light receiving part.

In embodiment, there is provided an image sensor module comprising: a substrate having a hole; an image sensor for image detection, which is attached a lower surface of the substrate and includes a light receiving part exposed through the hole; and a transparent member including a base part and a projecting part formed to be elevated from the base part, wherein the projecting part is inserted in the hole and the transparent member is attached to an upper surface of the substrate.

### BRIEF DESCRIPTION OF THE DRAWINGS

The above features and advantages of the present invention will become more apparent from the following detailed description when taken in conjunction with the accompanying drawings in which:
FIG. 1 is a sectional diagram of a conventional image sensor module whose light receiving part is sealed up according to a COF process; and
FIG. 2 is a sectional diagram of an image sensor module according to a preferred embodiment of the present invention.

### DETAILED DESCRIPTION

Embodiments of the present invention will be described herein below with reference to the accompanying drawings. For the purposes of clarity and simplicity, well-known functions or constructions are not described in detail as they would obscure the invention in unnecessary detail.

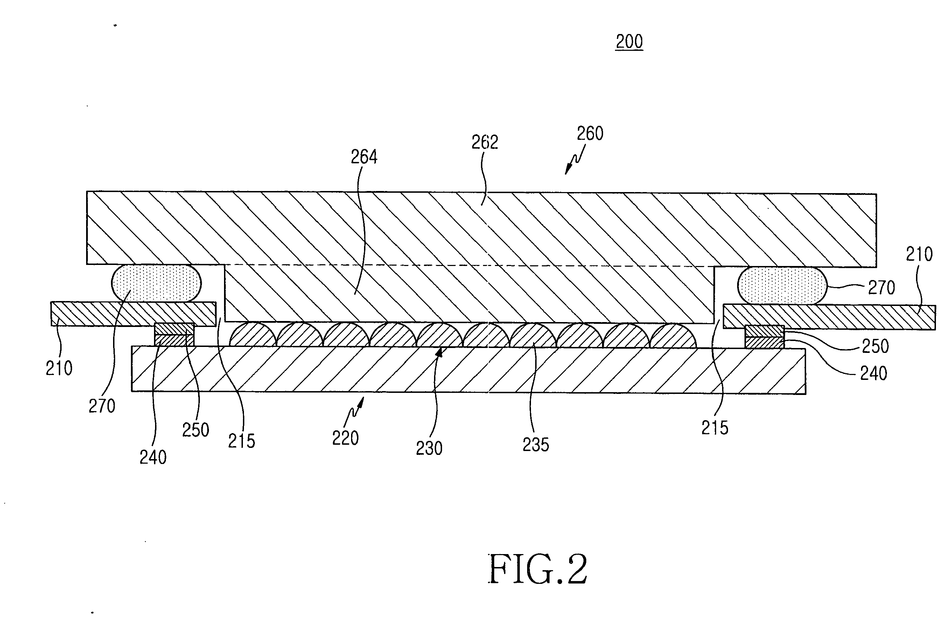

FIG. 2 is a sectional diagram of an image sensor module 200 according to an embodiment of the present invention. As shown, the image sensor module 200 includes a flexible printed circuit board (FPCB) 210, an image sensor 220, and an infrared (IR) filter 260.

The FPCB 210 includes a rectangular opening 215 having a predetermined size, and an epoxy 250 is spread on a lower surface of the FPCB 210 to be deployed around the opening 215. Herein, the epoxy 250 is spread to have a rectangular band shape. In addition, an epoxy 270 is spread on an upper surface of the FPCB 210 to be deployed around the opening 215 having the rectangular band shape.

The image sensor 220 includes a light receiving part 230, which is exposed on its surface and comprised of a plurality of pixels 235, and external connection terminals 240 deployed on its surface to envelop the light receiving part 230. The light receiving part 230 located on a center portion of the surface of the image sensor 220. The external connection terminals 240 having a rectangular band shape and separated from the light receiving part 230 by a predetermined distance are deployed on the surface of the image sensor 220. The external connection terminals 240 are also separated from each other by a predetermined gap. The image sensor 220 may be a CMOS image sensor or a CCD image sensor, and the external connection tenninals 240 may be bumps or pads. The image sensor 220 is attached to the lower surface of the FPCB 210 via the external connection tenninals 240 and the epoxy 250. That is, the image sensor 220 is attached to the lower surface of the FPCB 210 to cover a lower part of the opening 215, and the light receiving part 230 is exposed through the opening 215 of the FPCB 210.

The IR filter 260, which is a transparent member, includes a base part 262 having a rectangular flat board shape and a rectangular flat board shaped projecting part 264 formed to be elevated from the surface of the base part 262. The projecting part 264 has a smaller area than that of the base part 262 and is located at the center of the base part 262. In addition, since the projecting part 264 needs to be inserted into the opening 215, the projecting part 264 has a smaller area than that of the opening 215, and since the base part 262 should be attached to the upper surface of the FPCB 210, the base part 262 has a greater area than that of the opening 215. The IR filter 260 is attached to the upper surface of the FPCB 210 using the epoxy 270 so that the projecting part 264 is inserted into the opening 215 and covers an upper part of the opening 215. That is, the surface of an edge part (a circumference of the projecting part 264) of the base part 262 of the IR filter 260 is attached to the upper surface of the FPCB 210.

Now, a process of attaching the IR filter 260 will be described hereinafter.

First, a thickness of the projecting part 264 of the IR filter 260 is determined considering a thickness of the opening 215 (i.e., a thickness of the FPCB 210), an optimal compressed thickness of the epoxy 270 (a thickness of the non-compressed epoxy 270 is greater than this), and a distance between a lower end of the FPCB 210 and an upper end of the light receiving part 230. In addition, a shape of the FPCB 210 may be further considered. For example, if the distance between the lower end of the FPCB 210 and the upper end of the light receiving part 230 is 0, the thickness of the opening 215 is 40 µm, and the optimal compressed thickness of the epoxy 270 is 100 µm, then the thickness of the projecting part 264 is set to around 140 µm. Alternatively, the configuration of these components can be varied proportionally.

Second, in a state in which the projecting part 264 is arranged to be inserted into the opening 215 of the FPCB 210, the IR filter 260 is attached to the upper surface of the FPCB 210 by being pushed.

Third, if the surface of the projecting part 264 uniformly contacts the upper end of the light receiving part 230, pressure added to the IR filter 260 is removed.

When the surface of the projecting part 264 uniformly contacts with the upper end of the light receiving part 230, the arrangement of the IR filter 260 is automatically achieved. If tilting of the IR filter 260 (a phenomenon that the IR filter 260 slopes against the upper surface of the FPCB 210) is not generated, the epoxy 270 has a uniformly compressed thickness.

Furthermore, since the surface of the projecting part 264 uniformly contacts the upper end of the light receiving part 230, a probability that burrs or foreign bodies in the opening 215 intrude onto the light receiving part 230 due to an external shock is minimized.

As described above, an image sensor module according to the embodiment of the present invention is capable of sealing up a light receiving part of an image sensor using a transparent member comprised of a base part and a projecting part, thereby easily achieving airtightness and maintenance of the light receiving part due to an automatic arrangement function provided by the projecting part, while minimizing a phenomenon that burrs or foreign bodies in a hole of a substrate intrude onto the light receiving part.

While the invention has been shown and described with reference to a certain preferred embodiment thereof, it will be understood by those skilled in the art that various changes in form and details may be made therein without departing from the spirit and scope of the invention as defined by the appended claims.

## Claims

1. An image sensor module comprising:
a substrate having an opening;
an image sensor, attached to a lower surface of the substrate, having a light receiving part exposed through the opening; and
a transparent member including a base part and a projecting part formed to be elevated from the base part, wherein the projecting part is inserted through the opening so that the transparent member is attached to an upper
surface of the substrate.

2. The image sensor module of claim 1, wherein the surface of the projecting part uniformly contacts an upper end of the light receiving part.

3. The image sensor module of claim 1, wherein the substrate is a flexible printed circuit board (FPCB).

4. The image sensor module of claim 1, wherein the transparent member is an infrared (IR) filter.

5. The image sensor module of claim 1, wherein the image sensor and the transparent member are attached to the substrate using epoxies.

6. The image sensor module of claim 1, wherein the image sensor comprises one of a CMOS image sensor and a CCD image sensor.

7. The image sensor module of claim 1, wherein the projecting part has a smaller area than the base part and is located at the center of the base part.

8. The image sensor module of claim 1, wherein the projecting part has a smaller area than the opening.

9. An image sensor module comprising:
a substrate having an opening;
an image sensor, attached to a lower surface of the substrate, having a light receiving part exposed through the opening; and
an infrared (IR) filter having a base part and a projecting part coupled to the base part, the projecting part inserted through to be in contact with an upper surface of the substrate.

10. The image sensor module of claim 9, wherein the substrate is a flexible printed circuit board (FPCB).

11. The image sensor module of claim 9, wherein the light receiving part of the image sensor further includes a plurality of pixels at a center portion thereof.

12. The image sensor module of claim 9, wherein the light receiving part further comprising external connection terminals having a rectangular band shape and separated from the light receiving part by a predetermined distance.

13. The image sensor module of claim 12, wherein the external connection terminals are also separated from each other by a predetermined gap.

14. The image sensor module of claim 12, wherein the external connection terminals comprises one of bumps and pads.

15. The image sensor module of claim 9, wherein the image sensor comprises one of a CMOS image sensor and a CCD image sensor.

16. The image sensor module of claim 9, wherein the image sensor is attached to a lower surface of substrate via external connection terminals and epoxies.

17. The image sensor module of claim 9, wherein the projecting part has a smaller area than the base part and is located at the center of the base part.

18. The image sensor module of claim 9, wherein the projecting part has a smaller area than the opening.

19. The image sensor module of claim 9, wherein the surface of the projecting part uniformly contacts an upper end of the light receiving part.
